(19) Europäisches Patentamt

European Patent Office

Office européen des brevets

(11) EP 1 473 644 A2

(12) **EUROPEAN PATENT APPLICATION**

(43) Date of publication:
03.11.2004 Bulletin 2004/45

(51) Int Cl.7: **G06F 17/50**

(21) Application number: **04009701.6**

(22) Date of filing: **23.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **25.04.2003 IN de06322003**

(71) Applicant: **STMicroelectronics Pvt. Ltd**
**Noida 201 301, Uttar Pradesh (IN)**

(72) Inventors:
- **Sharma, Sunil Kumar**
  **Noida, UP - 201 301 (IN)**
- **Tomar, Ajay**
  **Noida, UP - 201 301 (IN)**
- **Samanta, Dhabalendu**
  **Delhi - 110 091 (IN)**

(74) Representative: **Cerbaro, Elena et al**
**c/o Studio Torta S.r.l. Via Viotti, 9**
**10121 Torino (IT)**

(54) **A method for mapping a logic circuit to a programmable look up table**

(57)     The present invention provides an improved method for mapping a logic circuit to a plurality of interconnectable, programmable look up tables (LUT) elements comprising steps of, forming logic element groups including individual logic elements and/ or previously formed logic element groups that are capable of being accommodative with in the fanin and /or fanout capacity of a target LUT, mapping the formed logic element group to the target LUT, and repeating the process for forming logic element groups and mapping to target LUTs for the entire network in a manner that at each stage only the unapped logic element/elements and mapped logic element groups of the previous stage are considered for mapping.

FIGURE 3

**Description**

**Field of the Invention:**

The present invention relates to Field Programmable Gate Arrays (FPGA) and more particularly, to an improved method for mapping a logic circuit to a programmable look up tables.

**Background of the Invention:**

A programmable logic array device has a plurality of logic elements connected though an interconnect architecture. Electrical circuits are mapped over these logic elements to enable the device to perform desired operations. Mapping of an electrical circuit to an FPGA is a time consuming process hence an technologies emphasizes to increase the speed of the mapping process.

The important objectives during mapping of an electrical circuit over an FPGA are, to map maximum number of circuit elements over a single logic element and to achieve a smallest possible tree of logic elements to realize the electrical circuit Different technology propose different method to achieving said objectives. For example, R. J. Francis; J. Rose et. al. [1] proposes a mapping algorithm that reduces delay by using bin packing to determine the gate level decomposition of every node in the network.

In another method suggested by'K. C. Chen, J. Cong, Y. Ding et.al [2] uses a graph based technology mapping package for delay optimization in logic elements. In this technology mapping is carried out in three main parts, transformation of an arbitrary network into a two input network technology mapping for delay minimization, and area optimization in the mapping solution through a direct acyclic graph (DAG)

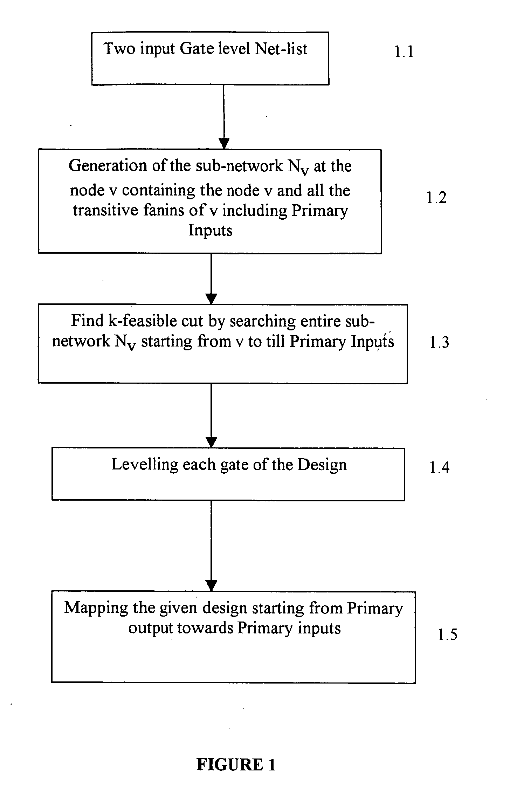

A polynomial time technology mapping algorithm has been proposed by K. C. Chen, J. Cong, Y. Ding et.al [3] in which a Flow-Map that optimally maps electrical circuit on FPGA for depth minimization by computing a minimum height for k-feasible cut a network. This algorithm is commonly used for technology mapping. The algorithm can be better understood by referring to the flowchart shown in **Figure 1.**

Figure 1 shows a flow diagram of the algorithm. According to this algorithm in the first step the gate level Net-list **1.1** containing information about the logic gates is inserted for mapping onto the LUTs in FPGAs. Now supposing that N denotes the given network of logic gates contained in the Net-list and $N_t(v)$ denotes a sub-network generated at a node v, the next step is to generate sub-network $N_t(v)$ at each node v **1.2** of the network N. The sub-network $N_t(v)$ contains the node v itself along with all the transitive fanins of node v including the primary inputs. Next, k-distinct paths are found in the sub-network $N_t(v)$ by applying known techniques such as depth first, breadth first search and the like. Subsequently, minimum height k-feasible cut is found in the sub-network $N_t(v)$ **1.3** starting from v till the primary inputs and LUTs are formed. The next step followed in the algorithm is to level each gate of the design **1.4** and subsequently, map the given design starting from the primary output towards the primary inputs **1.5** onto a LUT.

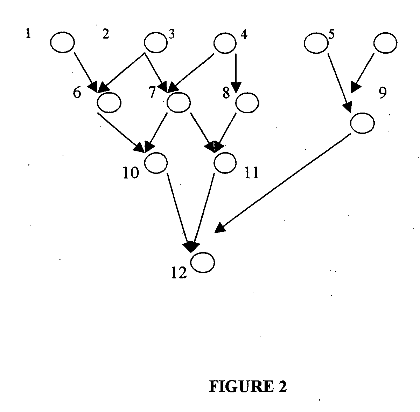

**Figure 2** shows the generation of sub-networks $N_t(v)$ using the algorithm discussed above. In this process at each node v of the network N. In the given figure, sub-network $N_t(12)$ generated at the node 12 starts from node 12 and continues till the primary nodes 1, 2, 3, 4 and 5. Thus, the sub-network can be mathematically represented as $N_t(12) = \{12, 11, 10, 9, 8, 7, 6, 5, 4, 3, 2, 1\}$ as it includes all the transitive fanins of node v, including the primary inputs. A four input LUT is formed at node 12 for the sub-network $N_t(v)$. Nodes inside the cone are 10, 11 and 12, while the fanin nodes of the cone are 6, 7, 8 and 9.

In another research article J. Cong et.al. [4] have suggested an algorithm for FPGA mapping technology. In this technique a number of depth relaxation operation are performed to obtain a new network with bounded increase in depth and advantageous to subsequent re-mapping for area minimization by gradually increasing depth bound..

An integrated approach for synthesizing and mapping has been disclosed by Francis, et al. [5]. This algorithm uses a global combinatorial optimization techniques to guide the Boolean synthesis process during depth minimization . The combinatorial optimization is achieved by computing series of minimum cuts of fixed hights in a network based on fast network computation and the Boolean optimization is achieved by efficient Ordered Binary Decision Diagrams (OBDD) based implementation of functional decomposition

In another approach by Francis, R. J., J. Rose et.al [6], a new algorithm has been discussed for technology mapping in which the method for choosing gate level decompositions based on binary packing is innovative.

Several other approaches have also been applied to achieve these objectives. However, most of these approaches results in either local optimal or exponential nature in time complexity. Hence, these approaches are too expensive and cannot be applied for all designs.

One of the ways for achieving this reduction of sub-network is as follows:

- Starting from the node v include all nodes till the k-feasible cut is found.
- Consider node v as $0^{th}$ level node, including all nodes up to a certain level say, 4 or 5.

Such reduction techniques do not give an optimal solution. or a near optimal solution.

The Flow-map algorithm described above suffers from a drawback, i.e., the runtime of the algorithm gets increased while constructing sub-networks and finding cut for each node of the circuit. This increase becomes even more prominent when the delay of a circuit increases.

## Summary of the Present Invention

The object of this invention is to obviate the above drawbacks in the prior art and provide a to a method for LUT based mapping for reducing computation time taken and providing a near depth optimal mapping solution.

To achieve above and other objects the invention provides an improved method for mapping a logic circuit to a plurality of interconnectable, programmable look up tables (LUT) elements comprising steps of:

- forming logic element groups including individual logic elements and/ or previously formed logic element groups that are capable of being accommodative with in the fanin and /or fanout capacity of a target LUT;
- mapping the formed logic element group to the target LUT, and;
- repeating the process for forming logic element groups and mapping to target LUTs for the entire network in a manner that at each stage only the unapped logic element/elements and mapped logic element groups of the previous stage are considered for mapping.

The invention also provides a method provides an ability to incorporate mapped logic elements groups upto any desired previous levels for the mapping to the target LUT.

## Brief Description of the Accompanying Drawings

The objects and advantages of the invention will become more apparent with reference to the following description and accompanying drawings, wherein:

**Figure 1** shows a flowchart depicting the steps to be followed in the conventional Flow-map algorithm for LUT mapping.

**Figure 2** shows the generation of sub-networks at each node v of the network N representing all logic gates to be mapped.

**Figure 3** shows the algorithm depicting the steps to be followed in the algorithm provided by the present invention for LUT mapping.

**Figure 4** shows construction of sub-networks according to the method of the present invention.

## Detailed Description

**Figure 1,** and **figure 2** have already been described in the background of the invention.

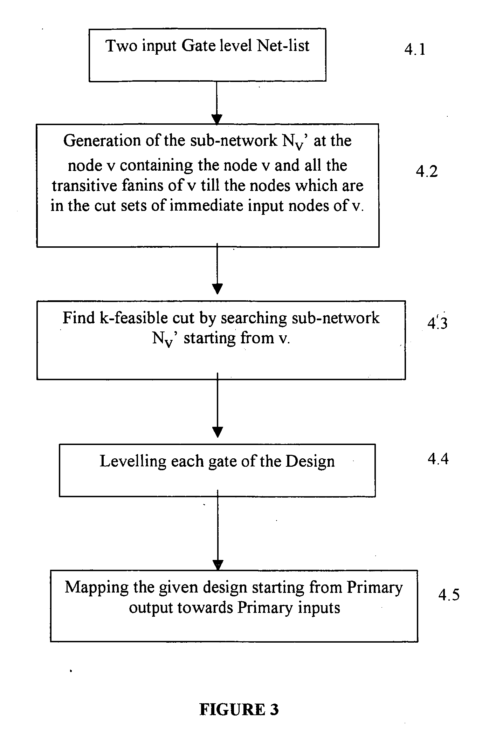

**Figure 3** shows the algorithm depicting the steps to be followed in the algorithm provided by the present invention for LUT mapping. First, the gate level Net-list is input for providing information about the logic gates to be mapped **4.1**. The next step **4.2** is the generation of the sub-network $N_t(v)$ at node v containing the node v itself along with all the transitive fanins of v till the nodes which are in the cut sets of immediate input nodes of v This step is an improvement over the conventional mapping methods as it significantly reduces the number of nodes to be considered for mapping each time a new node is to be mapped. Further, in step **4.3** the k-feasible cut is found out for the sub-network $N_t(v)$ by searching the sub-network starting from node v.

In the present method for constructing sub-network $N_t(v)$ for each node v of the network N, let $v_1$ be a node for which all fanins are primary inputs. Sub-network $N_t(v)$ consists of primary inputs, which have a path to v and v itself For constructing sub-network $N_t(v)$ at any node v of the network N,

Let $X = \{x_1, x_2,..., x_m\}$ be the set of immediate fanin nodes of a node v.
Let $C_i = \{ x_i^1, x_i^2, ..., x_i^k\}$ (i = 1, 2, ..., m)

be the k-feasible cut of the sub-network $N_t(x_i)$ generated at the node $x_i$.

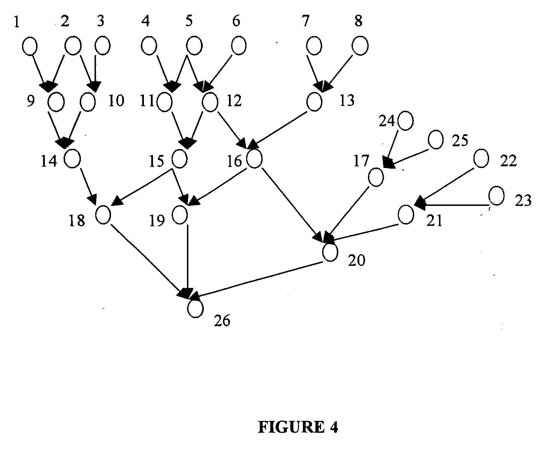

Then $N_t(v)$ consists of all nodes in $C_1, C_2, ...,C_m$ and all transitive fanouts of nodes in $C_1, C_2, ....,C_m$ which have path to v as shown in **Figure 4.**

In **figure 4**, suppose sub-networks $N_t(18)$, $N_t(19)$, $N_t(20)$ have already been constructed and the sub-network $N_t(26)$ has to be generated next at node 26. Further, suppose that number of input to each LUT is 4. The sets of fanin nodes for the sub-networks $N_t(18)$, $N_t(19)$, $N_t(20)$ are {9,10,11,12}, {4,5,6,13} and {12,13,17,21} respectively.

If the sub-network $N_t(26)$ is generated by following the steps of conventional mapping algorithms, then $N_t(26)$ will contain all nodes till the primary inputs. In mathematical terms $N_t(26)$= { 1, 2, 3, ... , 24, 25, 26}

On the other hand, when the sub-network $N_t(26)$ is generated using the method of the present invention, then it starts from node 26 and spans up to nodes for which the set of immediate fanins is the set: {9, 10, 11, 12}$\cup$ {4,5,6,13} $\cup${12,13,17,21}= {9, 10, 11, 12, 4, 5, 6, 13, 17, 21}. Therefore, according to this invention, the set of nodes that are not required to construct $N_t(26)$ is {1,2,3,4,5,6,7,8,22,23,24,25}.

As a result of this reduction in the number of nodes, the computational time taken gets reduced by about 50% as compared to the conventional methods. At the same time, this method gives a near depth optimal mapping solution. Moreover, for a circuit having delay, the execution time saving will be even more. This execution time saving may vary from x to 4x times. Results of this invention on few benchmark circuits for LUT formation have been tabulated in Table 1. Columns 2 and 3 of Table 1 are results for the Flow-map algorithm, while Columns 4 and 5 are results for the method of the present invention.

Table 1

| Design | Flow-map | | Proposed method | |
|---|---|---|---|---|
| | Depth | Time (seconds) | Depth | Time |
| Alu2 | 11 | 4.61 | 11 | 1.25 |
| Alu4 | 7 | 27.68 | 7 | 19.59 |
| Apex2 | 8 | 51.505 | 8 | 27.39 |
| Apex3 | 7 | 10.485 | 7 | 5.39 |
| B12 | 6 | 3.49 | 6 | 2.6 |
| C1355 | 4 | 33.848 | 5 | 3.4 |
| C499 | 4 | 11.847 | 5 | 1.4 |
| Count | 6 | .5 | 6 | .2 |
| Duke2 | 5 | 1.8 | 5 | 1.05 |
| Ex5p | 7 | 35.53 | 7 | 9.93 |
| i8 | 6 | 27.87 | 6 | 18.7 |
| i9 | 5 | 12.99 | 6 | 4.5 |
| Misex3 | 7 | 46.03 | 7 | 37.99 |
| S1196 | 7 | 4.19 | 7 | 2.16 |
| S1423 | 18 | 7.98 | 18 | 1.96 |
| S838 | 14 | 2.82 | 14 | 1.31 |
| S8381 | 6 | 2.96 | 6 | 1.16 |
| S1238 | 7 | 4.14 | 7 | 2.06 |
| Dalu-opt | 6 | 3.22 | 6 | 1 66 |
| Vg2 | 5 | 1.39 | 5 | .14 |
| X3 | 6 | 6 609 | 6 | 5.5 |
| Table5 | 7 | 7.01 | 7 | 2.8 |
| Table3 | 6 | 7.1 | 6 | 2.9 |
| | | | | |
| **TOTAL** | | 315.604 | | 152.14 |

Average Reduction in time = ((315.604 - 152.14) / 315 604) * 100 %

= 51.794 %

The description of the present invention has been presented for purposes of illustration and is not intended to be exhaustive or limited to the invention whose scope is only defined by the appended claims. Many modifications and variations will be apparent to those of ordinary skill in the art.

**References:**

1.   R. J. Francis, J. Rose, and Z. Vranesic, "Technology mapping of lookup table-based FPGAs for performance," in *IEEE/ACM International Conference on Computer- Aided Design (ICCAD), pp. 568-5 71, 1991.*

2.   K.-C. Chen, J. Cong, Y. Ding, A. B Kahng, and P. Trajmar, "DAG-Map: Graph based FPGA technology mapping for delay optimization," *IEEE Design & Test of Computers, pp. 7-20, Sept. 1992.*

3.   K.-C. Chen, J. Cong, Y. Ding, "Flow-map: An optimal technology mapping algorithm for delay optimization in lookup-table based FPGA designs," *IEEE Transactions on Computer Aided Design of Integrated Circuits and Systems CAD, vol. 13, pp. 1-12, Jan. 1994.*

4.   J. Cong and Y. Ding, "On area/depth trade-off in LUT-based FPGA technology mapping," in *30th ACM/IEEE Design Automation Conference (DAC), pp. 213-218, 1993.*

5.   J. Cong and Y. Ding, "Beyond the combinatorial limit in depth minimization for LUT-based FPGA designs," in *IEEE/ACM International Conference on Computer-Aided Design (ICCAD), pp. 110-114,Nov. 1993.*

6.   Francis, R J., J. Rose, and K. Chung, "Chortle: A Technology Mapping Program for Lookup Table-Based Field Programmable Gate Arrays," *Proc. 27th ACM/IEEE Design Automation Conference, pp. 613-619, June 1990.*

7.   Sundarajarao Mohan, Kamal Chaudhary, " Delay Optimized Mapping for Programmable Gate Arrays with Multiple sized Lookup Tables", *Xilinx Inc, Patent No. US 6,336,208 B1, Date of Patent Jan. 1, 2002*

**Claims**

**1.**   An improved method for mapping a logic circuit to a plurality of interconnectable, programmable look up tables (LUT) elements comprising steps of:

-   forming logic element groups including individual logic elements and/ or previously formed logic element groups that are capable of being accommodative with in the fanin and /or fanout capacity of a target LUT;
-   mapping the formed logic element group to the target LUT, and;
-   repeating the process for forming logic element groups and mapping to target LUTs for the entire network in a manner that at each stage only the unapped logic element/elements and mapped logic element groups of the previous stage are considered for mapping.

**2.**   An improved method for mapping a logic circuit as claimed in claim 1 further including the ability to incorporate mapped logic elements groups upto any desired previous levels for the mapping to the target LUT.

| Two input Gate level Net-list | 1.1 |

$\downarrow$

| Generation of the sub-network $N_v$ at the node v containing the node v and all the transitive fanins of v including Primary Inputs | 1.2 |

$\downarrow$

| Find k-feasible cut by searching entire sub-network $N_v$ starting from v to till Primary Inputs | 1.3 |

$\downarrow$

| Levelling each gate of the Design | 1.4 |

$\downarrow$

| Mapping the given design starting from Primary output towards Primary inputs | 1.5 |

**FIGURE 1**

**FIGURE 2**

Two input Gate level Net-list    4.1

Generation of the sub-network $N_v$' at the node v containing the node v and all the transitive fanins of v till the nodes which are in the cut sets of immediate input nodes of v.    4.2

Find k-feasible cut by searching sub-network $N_v$' starting from v.    4.3

Levelling each gate of the Design    4.4

Mapping the given design starting from Primary output towards Primary inputs    4.5

**FIGURE 3**

**FIGURE 4**